# EUROPEAN PATENT APPLICATION

(11) **EP 4 527 683 A1**
(43) Date of publication of application: **26.03.2025**
(21) Application number: 23803389.8
(22) Date of filing: 21.04.2023
(51) Int. Cl.: B60L 58/12, B60L 50/60, B60L 53/14, G05D 1/02, H02J 7/00, H02J 7/02

(54) **CONVEYOR VEHICLE SYSTEM AND METHOD FOR CONTROLLING CONVEYOR VEHICLE**

(30) Priority: 12.05.2022 JP 2022078653
(71) Applicant: Murata Machinery, Ltd., Kyoto-shi, Kyoto 601-8326 (JP)
(72) Inventor: KITAMURA, Wataru, Inuyama-shi, Aichi 484-8502 (JP)
(74) Representative: Hoffmann Eitle
(86) International application number: PCT/JP2023/015923
(87) International publication number: WO 2023/218907

(57) **Abstract**

[Means to Solve Problem] A controller 20 includes a charging instructor 21 that instructs to start charging each transport vehicle 10. The charging instructor 21 performs a first determination process to determine whether a charge rate of an entirety of the plurality of transport vehicles 10 is below a first threshold value, and instructs to start charging at least any one of the transport vehicles 10 if the charge rate of the entirety of the plurality of transport vehicles 10 is determined as being below the first threshold value. The charging instructor 21 performs a second determination process to determine whether the charge rate of each transport vehicle 10 is below a second threshold value that is lower than the first threshold value, and instructs to start charging each transport vehicle 10 if the charge rate of the transport vehicle 10 is determined as being below the second threshold value.

## Description

### Technical Field

The present invention relates to a transport vehicle system and a method of controlling transport vehicles.

### Background Art

Conventionally, transport vehicle systems that transport articles in factories and the like on the basis of transport instructions are known. In these transport vehicle systems, transport vehicles, which transport articles on the basis of transport instructions, are equipped with driving batteries, and charging facilities are provided to charge the batteries while the vehicles are stationary. Patent Literature 1 discloses a technique in which, when causing a transport vehicle with a battery voltage that has dropped to a level requiring charging to travel to the charging facility for charging, the transport vehicle that has been charging at each charging facility and has had the longest charging time is dispatched, ensuring a certain number of transport vehicles remain available on the main route.

### Citation List

### Patent Literature

[Patent Literature 1] Japanese Patent No. 4539887

### Summary of Invention

### Technical Problem

In the conventional technique, the battery voltage of each transport vehicle is checked individually, and any transport vehicle that has dropped to a level requiring charging is sent to be charged at a charging facility, and one of the transport vehicles that is already charging at the charging facility is returned to the main route while charging is still in progress. In other words, in the conventional technique, when multiple transport vehicles drop to a level requiring charging at the same time, multiple transport vehicles that are already charging at the charging facility are caused to return to the main route at the same time. As a result, in conventional technique, the presence of multiple transport vehicles within the system that are not fully charged means that transport vehicles in the system as a whole will need to be charged in a short period of time, resulting in a reduction in the transport efficiency of the entire system.

Thus, the present invention provides a transport vehicle system and a method of controlling transport vehicles capable of suppressing a decrease in the transport efficiency of the entire system.

### Means for Solving Problem

A transport vehicle system according to an aspect of the present invention is a transport vehicle system comprising: a plurality of transport vehicles that transport articles; a controller that assigns a transport instruction to any one of the plurality of transport vehicles; and a charger that is located on a route along which the plurality of transport vehicles can travel and supplies electric power to the transport vehicles, wherein the controller includes a charging instructor that instructs to start charging each transport vehicle, wherein the charging instructor performs a first determination process to determine whether a charge rate of an entirety of the plurality of transport vehicles is below a first threshold value, and instructs to start charging at least any one of the transport vehicles if the charge rate of the entirety of the plurality of transport vehicles is determined as being below the first threshold value, and wherein the charging instructor performs a second determination process to determine whether the charge rate of each transport vehicle is below a second threshold value that is lower than the first threshold value, and instructs to start charging each transport vehicle if the charge rate of the transport vehicle is determined as being below the

### second threshold value.

A method of controlling transport vehicles according to an aspect of the present invention is a method of controlling transport vehicles in a transport vehicle system comprising a plurality of transport vehicles that transport articles, a controller that assigns a transport instruction to any one of the plurality of transport vehicles, and a charger that is located on a route along which the plurality of transport vehicles can travel and supplies electric power to the transport vehicles, the method comprising steps, implemented by the controller, of: performing a first determination process to determine whether a charge rate of an entirety of the plurality of transport vehicles is below a first threshold value, and instructing to start charging at least any one of the transport vehicles if the charge rate of the entirety of the plurality of transport vehicles is determined as being below the first threshold value; and performing a second determination process to determine whether the charge rate of each transport vehicle is below a second threshold value that is lower than the first threshold value, and instructing to start charging each transport vehicle if the charge rate of the transport vehicle is determined as being below the second threshold value.

### Advantageous Effects of the Invention

According to the transport vehicle system and the method of controlling transport vehicles according to an aspect of the present invention, any one of the transport vehicles is instructed to start charging if the charge rate of the entire plurality of transport vehicles is below the first threshold value, and each transport vehicle the charge rate of which is below the second threshold value that is lower than the first threshold value is instructed to start charging. Thus, compared to the conventional technique, which instructs to start charging using only the individual charge rates of transport vehicles, it is possible to suppress multiple transport vehicles from being instructed to start charging at the same timing, thereby suppressing a decrease in the transport efficiency of the entire system.

In the transport vehicle system of the above aspect, the charging instructor may check a system margin rate, which indicates a degree of margin in the entirety of the plurality of transport vehicles, at predetermined timings against processing of the transport instruction, instruct to start charging any one of the transport vehicles if the degree of margin indicated by the system margin rate is higher than or equal to a predetermined degree and also the charge rate of the entirety of the plurality of transport vehicles is determined as being below the first threshold value, and instruct to start charging a transport vehicle if the degree of margin indicated by the system margin rate is higher than or equal to the predetermined degree and also the charge rate of the transport vehicle is determined as being below the second threshold value. According to such an aspect, charging instructions for the transport vehicles are given taking the system margin rate into account. Thus, it is possible to prevent situations where there is no transport vehicle to which a transport instruction can be assigned. In the transport vehicle system of the above aspect, the charging instructor may check the system margin rate periodically at the predetermined timings. According to such an aspect, the system margin rate is periodically checked while giving charging instructions to the transport vehicles. Thus, it is possible to prevent situations transport vehicles become unable to execute transport instructions due to a reduced charge rate. In the transport vehicle system of the above aspect, the charging instructor may check whether or not at least one of following is satisfied: an effective transport vehicle ratio, which serves as the system margin rate to represent a proportion of transport vehicles that are on standby relative to the entirety of the plurality of transport vehicles, is higher than or equal to a predetermined ratio; a transport volume of the entirety of the plurality of transport vehicles is below a predetermined transport volume; and a utilization rate of the entirety of the plurality of transport vehicles is below a predetermined utilization rate. According to such an aspect, in the transport vehicle system, the system margin rate is found using various information related to the transport efficiency. Thus, it is possible to suitably suppress a decrease in the transport efficiency of the entire system. In the transport vehicle system of the above aspect, if there are multiple vehicles having a charge rate below the first threshold value, the charging instructor may instruct to start charging two or more of the transport vehicles at different timings. According to such an aspect, multiple transport vehicles are not sent to charge at the same time. Thus, it is possible to suppress a decrease in the transport efficiency of the entire system. In the transport vehicle system of the above aspect, the charging instructor may instruct to start charging the transport vehicles in order from the transport vehicle closest to the charger. According to such an aspect, when multiple transport vehicles require charging, it is possible to improve charging efficiency. In the transport vehicle system of the above aspect, the charging instructor may instruct to start charging the transport vehicles in order from the transport vehicle with the lowest charge rate. According to such an aspect, it is possible to prevent an increase in the number of transport vehicles being unable to execute transport instructions due to a reduced charge rate. In the transport vehicle system of the above aspect, the controller may acquire state information of the plurality of transport vehicles through periodic communication with the plurality of transport vehicles. According to such an aspect, it is possible to identify the transport vehicles that are suitable for instructing charging. In the transport vehicle system of the above aspect, the plurality of transport vehicles may be able to move in a first direction and a second direction along a grid-patterned track that extends in a first direction and a second direction intersecting the first direction, and the charger may be provided so as to correspond to one of grid cells of the grid-patterned track. According to such an aspect, the present invention can be applied to a transport vehicle system arranged on a grid-patterned track.

### Brief Description of the Drawings

Fig. 1 is a diagram for describing a processing example of a transport vehicle system according to an embodiment.
Fig. 2 is a perspective view showing an example of the transport vehicle system according to the embodiment.
Fig. 3 is a perspective view showing an example of a transport vehicle according to the embodiment.
Fig. 4 is a front elevation view showing an example of the transport vehicle according to an embodiment.
Fig. 5 is a diagram showing an example of transmitting and receiving state information according to the embodiment.
Fig. 6 is a flowchart showing an example of the flow of processing performed by a controller according to the embodiment.
Fig. 7 is a diagram for describing another processing example of a charging instructor according to the embodiment.
Fig. 8 is a diagram for describing still another processing example of the charging instructor according to the embodiment.
Fig. 9 is a diagram showing an example of a charging instruction processing image according to the embodiment.
Fig. 10 is a diagram showing an example of a charging instruction processing image according to the conventional technique.

### Description of Embodiments

Hereunder, an embodiment will be described, with reference to the drawings. However, the present invention should not be considered as limited to the embodiment described below. In the drawings, scale may be changed as necessary to illustrate the embodiment, such as by enlarging, reducing or emphasizing a portion. In the drawings, an XYZ Cartesian coordinate system may be used to describe directions in each drawing. In the XYZ Cartesian coordinate system, the horizontal directions are taken as the X direction and the Y direction, and the vertical direction is taken as the Z direction. The traveling direction of the transport vehicle can change from the state shown in the figures to another direction, and may also travel along, for example, a curved direction in some cases. For each of the X direction, the Y direction, and the Z direction, description is made with a definition in which a direction indicated by an arrow is the positive (+) direction and a direction opposite to the direction indicated by the arrow is the negative (-) direction. The rotational direction about the Z axis is referred to as the θZ direction.

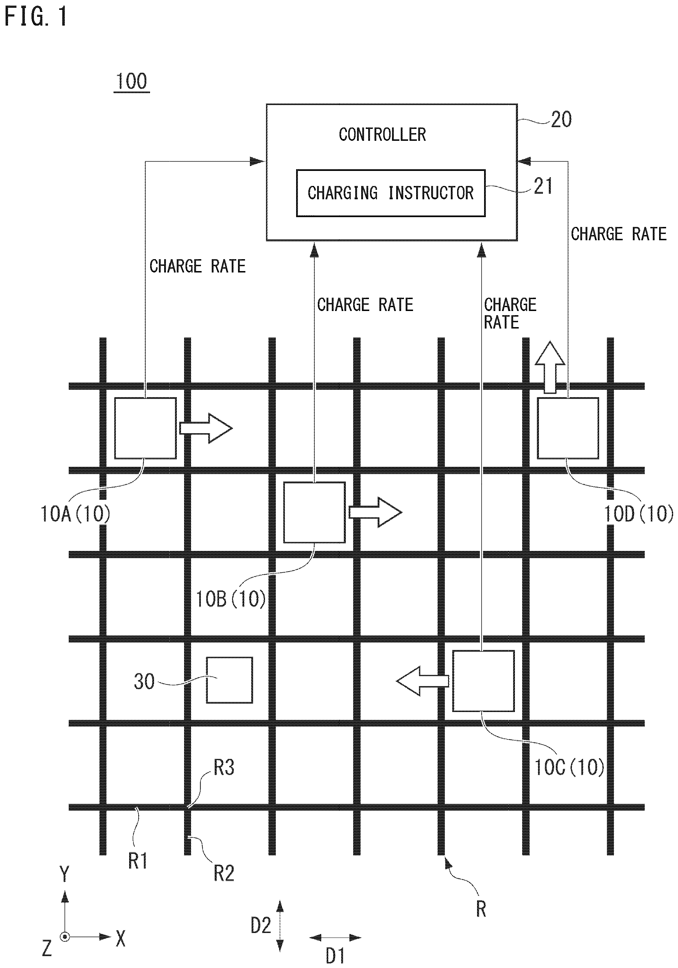

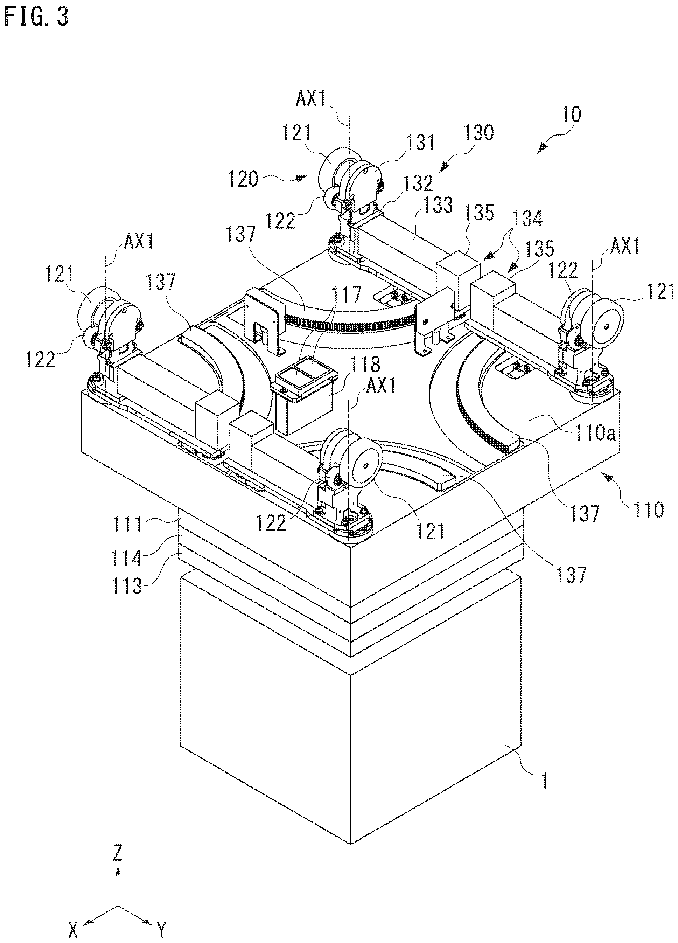

Fig. 1 is a diagram for describing a processing example of a transport vehicle system according to the embodiment. A transport vehicle system 100 is a system to transport articles 1 (see Fig. 3 and so forth) such as FOUPs (Front-Opening Unified Pods) containing semiconductor wafers and reticle pods containing reticles in a clean room of a semiconductor manufacturing factory, for example. In the embodiment, a transport vehicle 10 that travels on a grid-patterned track R suspended from the ceiling will be described as an example. The transport vehicle 10 may be a track-guided transport vehicle or a trackless transport vehicle that travels on the ground.

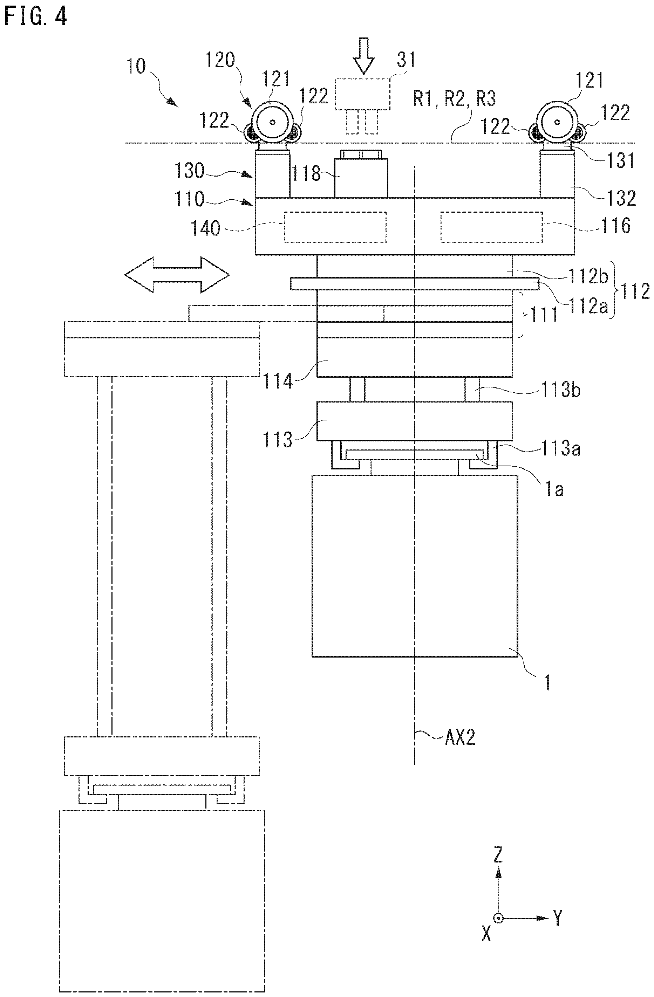

As shown in Fig. 1, the transport vehicle system 100 includes a plurality of transport vehicles 10 that transport articles 1, a controller 20 that assigns a transport instruction to one of the plurality of transport vehicles 10, and a charger 30 that is located on a route (for example, the grid-patterned track R) along which the plurality of transport vehicles 10 can move and that supplies electric power to the transport vehicles 10. Each transport vehicle 10 can move in a first direction D1 and a second direction D2 along the grid-patterned track R that extends in the first direction D1 and the second direction D2 intersecting the first direction D1. The grid-patterned track R is a type of track and is installed near the ceiling of a clean room. The charger 30 is provided so as to correspond to one of grid cells of the grid-patterned track R. The charger 30 supplies electric power to a battery 116 of the transport vehicle 10 (see Fig. 4). The grid-patterned track R has first tracks R1 provided along the X direction (for example, the first direction D1), second tracks R2 provided along the Y direction (for example, the second direction D2), and partial tracks R3 provided at intersections of the first tracks R1 and the second tracks R2. In Fig. 1, the four transport vehicles 10 are presented as transport vehicle 10A, transport vehicle 10B, transport vehicle 10C, and transport vehicle 10D, respectively. When not specifically distinguishing between the transport vehicle 10A, the transport vehicle 10B, the transport vehicle 10C, and the transport vehicle 10D, they will be simply referred to as "transport vehicle 10". However, the number of transport vehicles 10 is not limited to four.

Each transport vehicle 10 transmits its own state information to the controller 20 in response to a request (periodic request) from the controller 20. The controller 20 acquires state information of the multiple transport vehicles 10 through periodic communication with the multiple transport vehicles 10, and assigns a transport instruction to one of the transport vehicle 10 on the basis of the acquired state information. The state information includes, for example, identification information for identifying the transport vehicle 10, along with information related to the current location, destination, traveling state (for example, on standby, charging, traveling for pickup, traveling for unloading), and charge rate (remaining battery level). The transport vehicle 10 travels on the grid-patterned track R upon receiving a transport instruction from the controller 20. The transport instruction includes information on the transport route along which the transport vehicle 10 transporting an article 1 is scheduled to travel. The information on the transport route is information that designates at least a part of the traveling route from an origin to a destination of the transport vehicle 10.

In the configuration described above, the controller 20 includes a charging instructor 21 that instructs to start charging each transport vehicle 10. The charging instructor 21 performs a first determination process to determine whether the charge rate of the entire multiple transport vehicles 10 is below a first threshold value, and instructs to start charging at least any one of the transport vehicles 10 if the charge rate of the entire multiple transport vehicles 10 is determined as being below the first threshold value. Specifically, the charging instructor 21 calculates the charge rate for all of the multiple transport vehicles 10 present on the grid-patterned track R, on the basis of the information related to the charge rate (remaining battery level) contained in the state information received from each transport vehicle 10. Then, the charging instructor 21 performs the first determination process to determine whether the calculated charge rate of the entire multiple transport vehicles 10 are below the first threshold value. At this time, the charging instructor 21 instructs to start charging at least any one of the transport vehicles 10 if the charge rate of the entire multiple transport vehicles 10 is determined as being below the first threshold value in the first determination process. Here, the number of transport vehicles 10 to which the charging start instruction is to be given may be set in advance, on the basis of the scale of the transport vehicle system 100, the number of transport vehicles 10 to be introduced, and so forth. When the charge rate of the entire multiple transport vehicles 10 is determined as being below the first threshold value in the first determination process, the charging instructor 21 may identify the transport vehicle 10 whose charge rate is below the first threshold value on the basis of the information on the charge rate (remaining battery level) contained in the state information of each transport vehicle 10, and instruct to start charging the identified transport vehicles 10. At this time, the charging instructor 21 may instruct to start charging at least any one of the transport vehicles 10 whose charge rate is below the first threshold value.

The charging instructor 21 performs a second determination process to determine whether the charge rate of each transport vehicle 10 is below a second threshold value that is lower than the first threshold value, and instructs to start charging each transport vehicle 10 if the charge rate of the transport vehicle 10 is determined as being below the second threshold value. Specifically, the charging instructor 21 performs the second determination point process to determine whether the charge rate of each transport vehicle 10 is below the second threshold value that is lower than the first threshold value, on the basis of information related to the charge rate (remaining battery level) contained in the state information received from each transport vehicle 10. At this time, the charging instructor 21 identifies the transport vehicle 10 whose charge rate is below the second threshold value through the second determination process, and instructs to start charging the identified transport vehicle 10. Here, the second threshold value is, for example, a level requiring charging relative to the charge rate of the battery 116. That is to say, the controller 20 charges at least any one of the transport vehicles 10 when the overall charge rate of the system falls below a certain level, using the first threshold value, which is a level requiring charging and higher than the second threshold value, as the threshold value for the charge rate of the entire multiple transport vehicles 10. Thus, it is possible to shift the timing of instructing to start charging, and suppress a decrease in the transport efficiency of the entire transport vehicle system 100. In other words, the controller 20 determines which transport vehicle 10 should start charging by comparing the charge rate of the entire system with the threshold value, and directs the transport vehicle 10 that would not normally require charging yet to the charger 30. Thus, it is possible to shift the timing of instructing to start charging, and suppress a decrease in the transport efficiency. When instructing to start charging a transport vehicle 10 whose charge rate is below the first threshold value in the first determination process, the controller 20 preemptively instructs to charge the transport vehicle 10 with a low charge rate from the perspective of the entire system, even if the transport vehicle 10 would not normally require charging yet. Thus, it is possible to suppress a decrease in the transport efficiency of the entire transport vehicle system 100 without transport vehicles 10 that require charging (at the level requiring charging) occurring in a short period of time.

The charging instructor 21 may check the system margin rate, which indicates a degree of margin in the entire multiple transport vehicles 10, at predetermined timings against the processing of transport instructions, and instruct to start charging any one of the transport vehicles 10 if the degree of margin indicated by the system margin rate is higher than or equal to a predetermined degree and also the charge rate of the entire multiple transport vehicles 10 is determined as being below the first threshold value. The charging instructor 21 may instruct to start charging a transport vehicle 10 (a transport vehicle 10 with a charge rate below the second threshold value) if the degree of margin indicated by the system margin rate is higher than or equal to the predetermined degree and also the charge rate of the transport vehicle 10 is determined as being below the second threshold value. Specifically, the charging instructor 21 checks whether or not at least one of following conditions is satisfied: the effective transport vehicle ratio, which serves as the system margin rate to represent the proportion of transport vehicles 10 that are on standby relative to the entire multiple transport vehicles 10, is higher than or equal to a predetermined ratio; the transport volume of the entire multiple transport vehicles 10 is below a predetermined transport volume; and the utilization rate of the entire multiple transport vehicles 10 is below a predetermined utilization rate. If at least one of these conditions is satisfied, it is determined that there is a sufficient system margin.

The effective transport vehicle ratio corresponds to the ratio of transport vehicles 10 that can execute transport instructions (that are available for executing transport instructions), and can be found, for example, by calculating the ratio of transport vehicles 10 on standby to the total number of transport vehicles 10, on the basis of the traveling state contained in state information. The transport volume corresponds to the number of transport instructions per unit time, or the weighted value for transport instructions with longer transport distances added to the number of transport instructions per unit time. The utilization rate corresponds to the ratio of transport vehicles 10 that are operating throughout the entire transport vehicle system 100, and can be found, for example, by calculating the ratio of transport vehicles 10 that are currently traveling for pickup or traveling for unloading, on the basis of the traveling state contained in state information. The threshold value for each item of the system margin rate can be set as appropriate, depending on the layout, transport pattern, and so forth of the transport vehicle system 100. For example, the predetermined transport distance may be set smaller than the limit value of the transport distance at which the transport instructions can be processed by the entire multiple transport vehicles 10, thereby allowing a margin in the execution of transport. For example, the predetermined utilization rate may be set lower than the limit value of the utilization rate of the entire multiple transport vehicles 10, thereby allowing a margin in the number of operational transport vehicles 10. The charging instructor 21 checks the system margin rate periodically at predetermined timings. For example, the cycle for checking the system margin rate is longer than the cycle for sending state information from each transport vehicle 10. As an example of the embodiment, the cycle for checking the system margin rate is approximately once per minute, whereas the cycle for transmitting state information is once every few seconds. After having checked the system margin rate as described above, or prior to checking the system margin rate, the charging instructor 21 executes the first determination process and the second determination process.

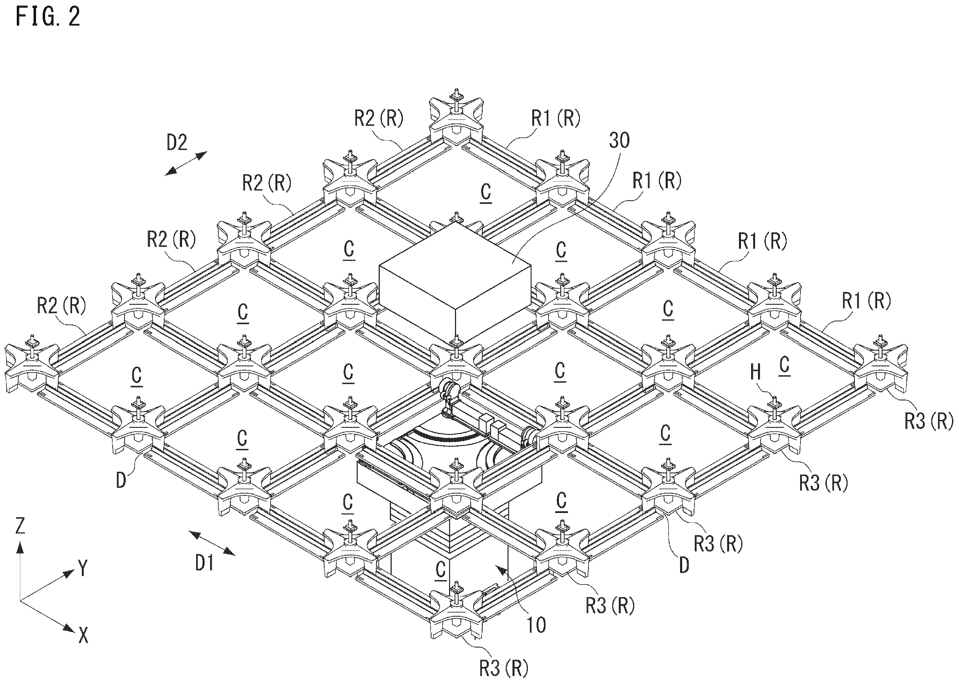

Fig. 2 is a perspective view showing an example of the transport vehicle system according to the embodiment. As described above, the transport vehicle system 100 is a system to transport articles 1 such as FOUPs containing semiconductor wafers and reticle pods containing reticles in a clean room of a semiconductor manufacturing factory, for example. The transport vehicles 10 and the charger 30 are arranged on the grid-patterned track R. The grid-patterned track R is provided in a state of being suspended from the ceiling via suspenders H. Multiple first tracks R1 are provided along the X direction (for example, the first direction D1). Multiple second tracks R2 are provided along the Y direction (for example, the second direction D2). In the present embodiment, the first direction D1, along which the first tracks R1 are provided, and the second direction D2, along which the second tracks R2 are provided, orthogonally intersect with each other. The partial track R3 is arranged at each portion where the first track R1 and the second track R2 intersect with each other. Between the first track R1 and the partial track R3 and between the second track R2 and the partial track R3, there is provided a gap D. The gap D is a portion through which a coupler 130 (see Fig. 3) serving as a part of the transport vehicle 10 passes when the transport vehicle 10 having traveled on the first track R1 crosses the second track R2 or when the transport vehicle 10 having traveled on the second track R2 crosses the first track R1. Therefore, the gap D is provided with a width that allows the coupler 130 to pass therethrough. The first tracks R1, the second tracks R2, and the partial tracks R3 are provided along the same or substantially the same horizontal plane. In the grid-patterned track R, the first tracks R1 and the second tracks R2 orthogonally intersect with each other, thereby establishing a state where a plurality of cells C are adjacent to each other as viewed in a plan view. A single cell C is a region or a space surrounded by two first tracks R1 adjacent to each other in the Y direction and two second tracks R2 adjacent to each other in the X direction.

Fig. 3 is a perspective view showing an example of the transport vehicle according to the embodiment. Fig. 4 is a front elevation view showing an example of the transport vehicle according to an embodiment. As shown in Fig. 3 and Fig. 4, the transport vehicle 10 has a main body 110, travelers 120, couplers 130, and a controller 140. The transport vehicle 10 moves along the grid-patterned track R and transports articles 1 such as FOUPs and reticle pods. Multiple transport vehicles 10 may be arranged in the grid-patterned track R. By transporting articles 1 by multiple transport vehicles 10, it is possible to improve the efficiency of transporting articles 1.

The main body 110 is arranged below the grid-patterned track R (on the -Z side). The main body 110 is formed, for example, in a rectangular shape as seen in a plan view. Therefore, an upper face 110a of the main body 110 has a rectangular shape and has four corners. The main body 110 is formed in a size that fits in a single cell C within the grid-patterned track R as viewed in a plan view. Therefore, in the grid-patterned track R, there is no interference between the transport vehicles 10 traveling adjacent to each other. The main body 110 has an article holder 113 to hold an article 1, a lift driver 114 to raise or lower the article holder 113 in the vertical direction, and a lateral extender 111 to move the lift driver 114. The article holder 113 suspends and holds an article 1 by grasping a flange 1a provided on the upper part of the article 1. The article holder 113 is, for example, a chuck having claws 113a movable in the horizontal direction, and inserts the claws 113a under the flange 1a of the article 1 and lifts the article holder 113, to thereby suspend and hold the article 1. The article holder 113 is connected to the lower end of suspenders 113b such as wires and belts.

The lift driver 114 is, for example, a hoist, and lowers the article holder 113 by feeding out the suspenders 113b and lifts the article holder 113 by taking up the suspenders 113b. The lift driver 114 is controlled by the controller 140 to raise or lower the article holder 113 at a predetermined speed. Also, the lift driver 114 is controlled by the controller 140 to maintain the article holder 113 at a target height. The lateral extender 111 has a plurality of movable plates arranged stacked, for example, in the Z direction. The movable plates can move in the Y direction. The lift driver 114 is mounted on the lowermost movable plate. The lateral extender 111 can, by moving the movable plates by means of a driver not shown in the drawings, extend laterally with respect to the traveling direction the lift driver 114 attached to the lowermost movable plate and the article holder 113.

The rotator 112 has a rotation member 112a and a rotation driver 112b. The rotation member 112a is provided so as to be rotatable in an axial direction about the Z axis. The rotation member 112a supports the lateral extender 111. An electric motor or the like is used for the rotation driver 112b and causes the rotation member 112a to rotate in the axial direction about the Z direction axis. The rotator 112 can, by rotating the rotation member 112a by means of the driving force from the rotation driver 112b, rotate the lateral extender 111 (the lift driver 114 and the article holder 113) in the axial direction about the Z direction axis. In addition to the rotator 112 to control the direction of laterally extending the lift driver 114 and the article holder 113, a rotator to control the attitude of the lift driver 114 and the article holder 113 within the horizontal plane may be further provided between the lateral extender 111 and the lift driver 114.

The main body 110 includes a battery 116 and charging electrodes 117. The battery 116 is arranged inside the main body 110. The battery 116 stores electric power to be supplied to the travelers 120, the rotation driver 112b, the lift driver 114, and so forth of the transport vehicle 10. A secondary battery such as a lithium ion battery is used for the battery 116. The capacity of the battery 116 is determined on the basis of electric power used in the transport vehicle 10, operating time thereof, and so forth. The charging electrodes 117 are held by a holder 118 and are arranged on the upper face 110a of the main body 110. The charging electrodes 117 are provided side by side at two locations on the upper face side of the holder 118. One of the two charging electrodes 117 is electrically connected to the + side terminal of the battery 116. The other charging electrode 117 is electrically connected to the - side terminal of the battery 116. Electric power is supplied to the battery 116 from the charger 30 (a terminal 31 of the charger 30) via the charging electrodes 117.

Each traveler 120 has a traveling wheel 121 and auxiliary wheels 122. The traveling wheel 121 is arranged in each of the four corners on the upper face 110a of the main body 110. Each traveling wheel 121 is rotatably supported on the coupler 130 by a rotation shaft not shown in the drawings. This rotation shaft is provided in parallel or substantially parallel along the XY plane (horizontal plane). Therefore, the traveling wheel 121 can rotate about the axis line of the rotation shaft along the horizontal direction. Each traveling wheel 121 is driven to rotate by the driving force of a traveling driver 133. Each traveling wheel 121 rolls on the traveling surfaces of the first track R1, the second track R2, and the partial track R3 of the grid-patterned track R, causing the transport vehicle 10 to travel. Each traveling wheel 121 is provided so as to be able to pivot in the θZ direction about the pivot axis AX1 along the Z direction. The traveling wheel 121 can, by pivoting in the θZ direction, change the traveling direction thereof from the first direction D1 to the second direction D2 or from the second direction D2 to the first direction D1. The configuration is not limited to driving all of the four traveling wheels 121 to rotate by the drive force of the traveling driver 133, and some of the four traveling wheels 121 may be driven to rotate.

The auxiliary wheels 122 are each arranged in front and rear of the traveling wheel 121 in the traveling direction. As with the traveling wheel 121, each auxiliary wheel 122 can rotate about the axis line of the rotation axis thereof parallel or substantially parallel along the XY plane. The lower end of the auxiliary wheel 122 is arranged higher than the lower end of the traveling wheel 121. Therefore, when the traveling wheel 121 is traveling on the traveling surfaces, the auxiliary wheels 122 do not come into contact with the traveling surfaces. When the traveling wheel 121 passes through the gap, the auxiliary wheels 122 come into contact with the traveling surfaces, preventing the traveling wheel 121 from falling. The configuration is not limited to providing two auxiliary wheels 122 for a single traveling wheel 121, and for example, a single auxiliary wheel 122 may be provided for a single traveling wheel 121, or no auxiliary wheel 122 may be provided.

The coupler 130 connects the main body 110 and the traveler 120. The coupler 130 is provided at each of the four corners on the upper face 110a of the main body 110. The main body 110 is suspended by the coupler 130 and is arranged below the grid-patterned track R. The coupler 130 has a support member 131 and a connection member 132. The support member 131 rotatably supports the rotation axle of the traveling wheel 121 and the rotation axles of the auxiliary wheels 122. The relative positions between the traveling wheel 121 and the auxiliary wheel 122 are maintained by the support member 131.

The connection member 132 extends downward from the support member 131 and is coupled to the upper face 110a of the main body 110 to hold the main body 110. The connection member 132 therein includes a transmission for transmitting the driving force of the traveling driver 133 to the traveling wheel 121. This transmission may be of a configuration in which a chain or a belt is used, or a configuration in which a gear train is used. The connection member 132 is provided so as to be able to pivot in the θZ direction about the pivot axis AX1. The rotation of the connection member 132 about the pivot axis AX1 can cause the traveling wheel 121 to pivot in the θZ direction.

The traveling driver 133 and the steerer 134 are provided in the coupler 130. The traveling driver 133 is attached to the connection member 132. The traveling driver 133 is a drive source for driving the traveling wheel 121, and for example, an electric motor or the like is used therefor. Each of the four traveling wheels 121 is driven by the traveling driver 133 to serve as a driving wheel. The four traveling wheels 121 are controlled by the controller 140 so as to rotate at the same or substantially the same rotation speed.

The steerer 134 causes the connection member 132 of the coupler 130 to rotate about the pivot axis AX1 to thereby cause the traveling wheel 121 to pivot in the θZ direction. The traveling direction of the transport vehicle 10 can be changed from the first direction D1 to the second direction D2 or from the second direction D2 to the first direction D1, by causing the traveling wheel 121 to pivot in the θZ direction.

The steerer 134 has a drive source 135, and a pinion gear and a rack 137, which are not shown in the drawings. The drive source 135 is mounted on a side face of the traveling driver 133 away from the pivot axis AX1. As the drive source 135, for example, an electric motor or the like is used. The pinion gear is mounted on the lower face side of the drive source 135, and is driven to rotate in the θZ direction by the driving force generated by the drive source 135. The pinion gear is of a circular shape as seen in a plan view and has a plurality of teeth on the outer circumference thereof along the circumferential direction. The rack 137 is fixed to the upper face 110a of the main body 110. The rack 137 is provided at each of the four corners on the upper face 110a of the main body 110, and is provided having an arc shape centered on the pivot axis AX1 of the traveling wheel 121. The rack 137 has multiple teeth which mesh with the teeth of the pinion gear, on the outer circumference thereof along the circumferential direction.

The pinion gear and the rack 137 are each arranged in the state where the teeth of the pinion gear and the teeth of the rack 37 are in mesh with each other. As the pinion gear rotates in the θZ direction, the pinion gear moves in the circumferential direction about the pivot axis AX1 along the outer circumference of the rack 137. This movement of the pinion gear causes the traveling driver 133 and the steerer 134 to pivot together with the pinion gear in the circumferential direction about the pivot axis AX1.

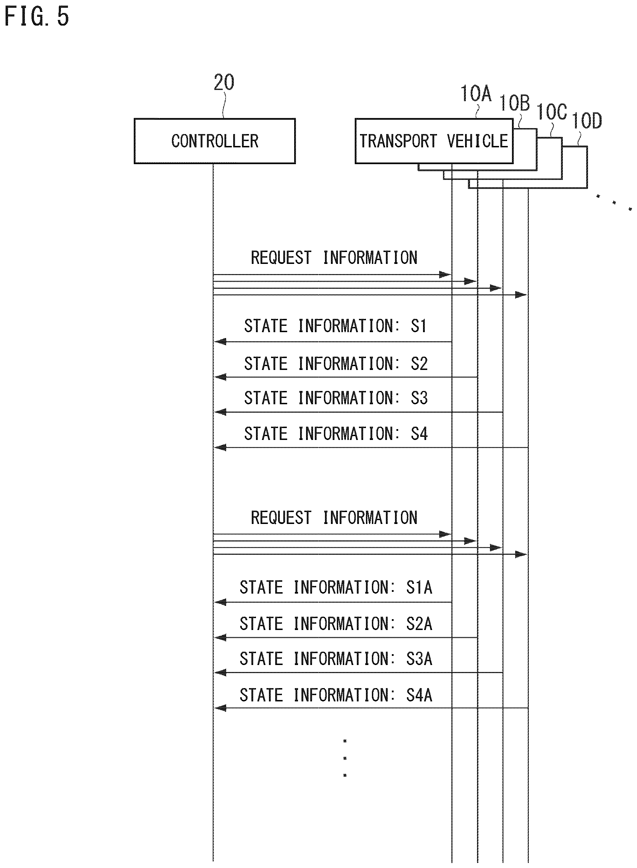

Fig. 5 is a diagram showing an example of transmitting and receiving state information according to the embodiment. As shown in Fig. 5, the controller 20 transmits a state information request to each of the transport vehicles 10 (for example, transport vehicles 10A, 10B, 10C, and 10D) through periodic communication. As a result, each transport vehicle 10 transmits its state information to the controller 20. Specifically, the transport vehicle 10A transmits its own state information S1 (state information S1A) to the controller 20. The transport vehicle 10B similarly transmits its own state information S2 (state information S2A) to the controller 20. The transport vehicle 10C similarly transmits its own state information S3 (state information S3A) to the controller 20. The transport vehicle 10D similarly transmits its own state information S4 (state information S4A) to the controller 20.

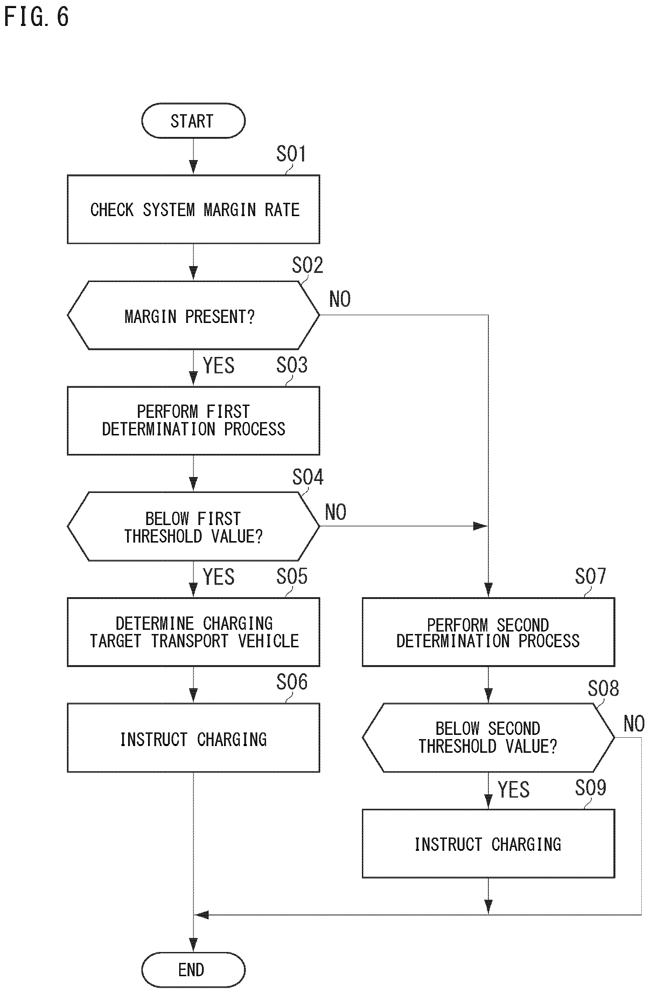

Fig. 6 is a flowchart showing an example of the flow of processing performed by a controller according to the embodiment. Fig. 6 shows an example in which the system margin rate is checked prior to the execution of the first determination process and the second determination process. As shown in Fig. 6, the charging instructor 21 checks the system margin rate (Step S01). Specifically, the charging instructor 21 checks whether at least one of the following is satisfied: the effective transport vehicle ratio is higher than or equal to a predetermined ratio; the transport volume is lower than a predetermined transport volume; and the utilization rate is lower than a predetermined utilization rate. Then, if there is a margin in the system margin rate (Step S02: YES), the charging instructor 21 executes the first determination process (Step S03). Specifically, the charging instructor 21, upon determining that there is a margin by checking the system margin rate, calculates the charge rate for all of the multiple transport vehicles 10 present on the grid-patterned track R, on the basis of the information related to the charge rate contained in the state information received from each transport vehicle 10.

Subsequently, if the charge rate calculated through the first determination process is below the first threshold value (Step S04: YES), the charging instructor 21 determines the charging target transport vehicle 10 to be charged (Step S05) and instructs to charge the determined charging target transport vehicle 10 (Step S06). Specifically, if the calculated charge rate for the entire multiple transport vehicles 10 is determined as being below the first threshold value, the charging instructor 21 determines at least one of the transport vehicles 10 as a charging target and instructs to start charging the transport vehicle 10 determined as the charging target. That is to say, when the system margin rate has a margin and the charge rate of the entire system is below the first threshold value, the controller 20 prompts at least one of the transport vehicles 10 to charge early. As described above, the charging instructor 21 may determine, on the basis of information related to the charge rate contained in the state information of each transport vehicle 10, that a transport vehicle 10 having a charge rate below the first threshold value (at least any one of the transport vehicles 10 having a charge rate below the first threshold value) as a charging target.

If there is no margin in the system margin rate (Step S02: NO), the charging instructor 21 executes the second determination process (Step S07). Specifically, the charging instructor 21, upon determining that there is no margin by checking the system margin rate, determines whether the charge rate of each transport vehicle 10 is below the second threshold value that is lower than the first threshold value, on the basis of the information related to the charge rate contained in the state information received from each transport vehicle 10. Then, if the charge rate is below the second threshold value on the basis of the second determination process (Step S08: YES), the charging instructor 21 instructs to charge the transport vehicle 10 (Step S09). Specifically, if there is a transport vehicle 10 whose charge rate is below the second threshold value as a result of the second determination process, the charging instructor 21 instructs to charge the transport vehicle 10. On the other hand, if the charge level is not below the second threshold value on the basis of the second determination process (Step S08: NO), the charging instructor 21 ends the processing. Specifically, if there is no transport vehicle 10 whose charge rate is below the second threshold value as a result of the second determination process, the charging instructor 21 ends the processing because there is no transport vehicle 10 that currently requires charging. In other words, if there is no margin in the system margin rate, the controller 20 prompts to charge the transport vehicle 10 that requires charging, without prompting to charge at a timing that is different from the usual timing.

If the charge level calculated through the first determination process is not below the first threshold value (Step S04: NO), the charging instructor 21 executes the second determination process. Specifically, the charging instructor 21, upon determining that the calculated charge rate of the entire multiple transport vehicles 10 is not below the first threshold value, determines whether the charge rate of each transport vehicle 10 is below the second threshold value that is lower than the first threshold value, on the basis of the information related to the charge rate contained in the state information received from each transport vehicle 10. That is to say, when the system margin rate has a margin and the charge rate of the entire system is not below the first threshold value, the controller 20 checks whether or not there is any transport vehicle 10 that requires charging. In other words, when the charge rate of the entire system is relatively high but there is a transport vehicle 10 that requires charging, the controller 20 prompts to charge the transport vehicle 10.

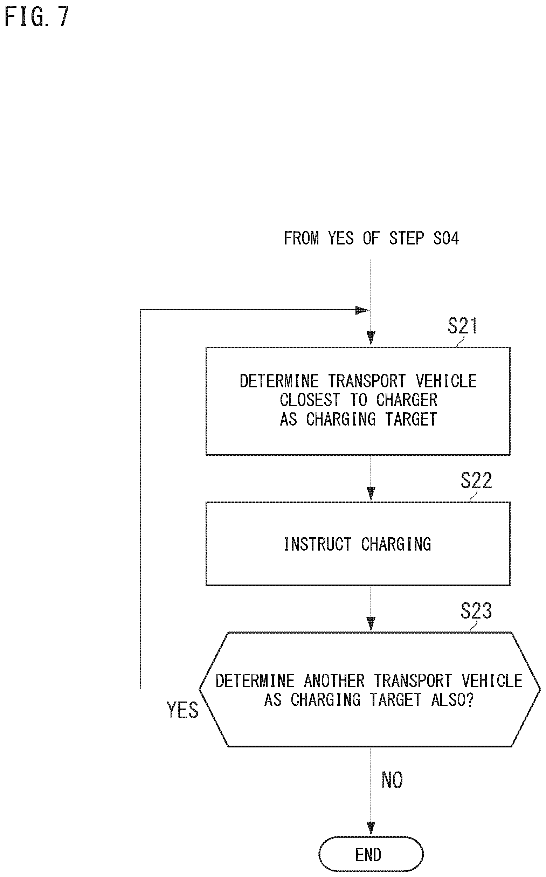

Fig. 7 is a diagram for describing another processing example of the charging instructor according to the embodiment. In addition to what has been described in the above embodiment, the charging instructor 21 may instruct to start charging two or more transport vehicles at different timings. Specifically, when instructing to start charging two or more transport vehicles, the charging instructor 21 may instruct to start charging the transport vehicles 10 in order from the transport vehicle 10 closest to the charger 30.

As shown in Fig. 7, if the charge rate calculated through the first determination process is below the first threshold value (Step S04: YES), the charging instructor 21 determines the transport vehicle 10 closest to the charger 30 as a charging target (Step S21) and instructs to charge the transport vehicle 10 determined as the charging target (Step S22). Specifically, the charging instructor 21, upon determining that the calculated charge rate of the entire multiple transport vehicles 10 is below the first threshold value, determines the transport vehicle 10 that is closest to the charger 30 as a charging target on the basis of information related to the current location contained in the state information of each transport vehicle 10. Thereafter, the charging instructor 21 instructs to charge the transport vehicle 10 determined as the charging target.

If another transport vehicle 10 is also determined as being a charging target (Step S23: YES), the charging instructor 21 executes the process of Step S21 again. On the other hand, if another transport vehicles 10 is not determined as being a charging target (Step S23: NO), the charging instructor 21 ends the processing. Specifically, after having instructed to charge a transport vehicle 10 determined as a charging target, if another transport vehicle 10 is also determined as a charging target, the charging instructor 21 determines the transport vehicle 10 closest to the charger 30 as being a charging target and instructs to charge the transport vehicle 10 that is determined as the charging target. After having instructed to charge the transport vehicle 10 determined as being a charging target, if another transport vehicle 10 is not determined as the charging target, the charging instructor 21 ends the processing.

In the case where the charger 30 becomes unavailable for successive charging instructions to transport vehicles 10, the controller 20 may execute the instructions at certain intervals. In other words, the controller 20 instructs to charge the transport vehicles 10 closest to the charger 30 (in order from the transport vehicle 10 closest to the charger 30) at certain intervals between the instruction, because it is undesirable for the transport efficiency to decrease due to a charging wait that arises when multiple transport vehicles 10 are sent for charging at the same time. Also, in the case where a transport vehicle 10 with a charging rate below the first threshold value is determined as a charging target, if multiple transport vehicles 10 are charging targets, the charging instructor 21 may instruct to charge the charging target transport vehicles 10 in order from the transport vehicle 10 closest to the charger 30, at certain intervals.

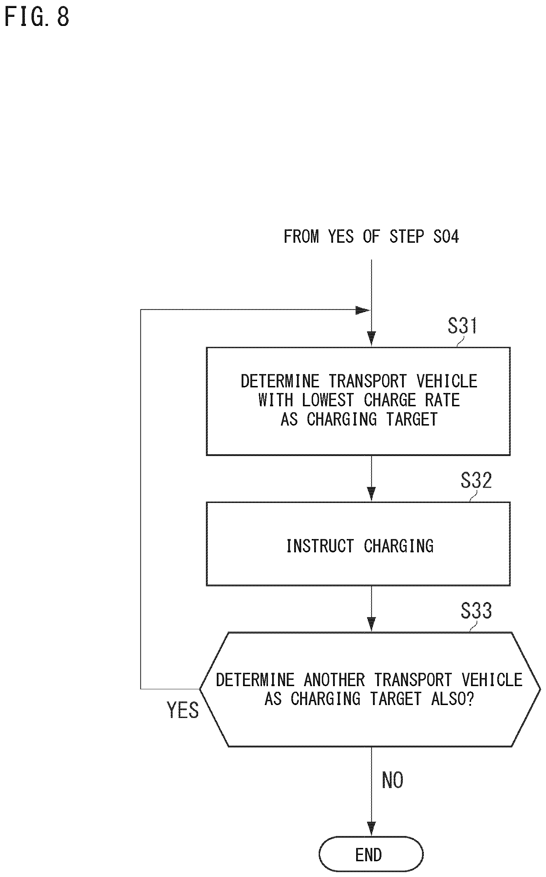

Fig. 8 is a diagram for describing another processing example of the charging instructor according to the embodiment. In addition to what has been described in the above embodiment, the charging instructor 21 may instruct to start charging two or more transport vehicles at different timings. Specifically, when instructing to start charging two or more transport vehicles, the charging instructor 21 may instruct to start charging the transport vehicles 10 in order from the transport vehicle 10 with the lowest charge rate.

As shown in Fig. 8, if the charge rate calculated through the first determination process is below the first threshold value (Step S04: YES), the charging instructor 21 determines the transport vehicle 10 with the lowest charge rate as a charging target (Step S31) and instructs to charge the transport vehicle 10 determined as the charging target (Step S32). Specifically, the charging instructor 21, upon determining that the calculated charge rate of the entire multiple transport vehicles 10 is below the first threshold value, determines the transport vehicle 10 with the lowest charge rate as a charging target, on the basis of information related to the charge rate contained in the state information of each transport vehicle 10. Then, the charging instructor 21 instructs to charge the transport vehicle 10 determined as the charging target.

If another transport vehicle 10 is also determined as being a charging target (Step S33: YES), the charging instructor 21 executes the process of Step S31 again. On the other hand, if another transport vehicles 10 is not determined as being a charging target (Step S33: NO), the charging instructor 21 ends the processing. Specifically, after having instructed to charge a transport vehicle 10 determined as a charging target, if another transport vehicle 10 is also determined as a charging target, the charging instructor 21 determines the transport vehicle 10 with the lowest charge rate as being a charging target and instructs to charge the transport vehicle 10 that is determined as the charging target. After having instructed to charge the transport vehicle 10 determined as being a charging target, if another transport vehicle 10 is not determined as the charging target, the charging instructor 21 ends the processing. In the case where the charger 30 becomes unavailable for successive charging instructions to transport vehicles 10, the controller 20 may execute the instructions at certain intervals. In other words, the controller 20 instructs to charge the transport vehicles 10 with the lowest charge rate (in order from the transport vehicle 10 with the lowest charge rate) at certain intervals between the instruction, because it is undesirable for the transport efficiency to decrease due to a charging wait that arises when multiple transport vehicles 10 are sent for charging at the same time. Also, in the case where a transport vehicle 10 with a charging rate below the first threshold value is determined as a charging target, if multiple transport vehicles 10 are charging targets, the charging instructor 21 may instruct to charge the charging target transport vehicles 10 in order from the transport vehicle 10 with the lowest charge rate, at certain intervals.

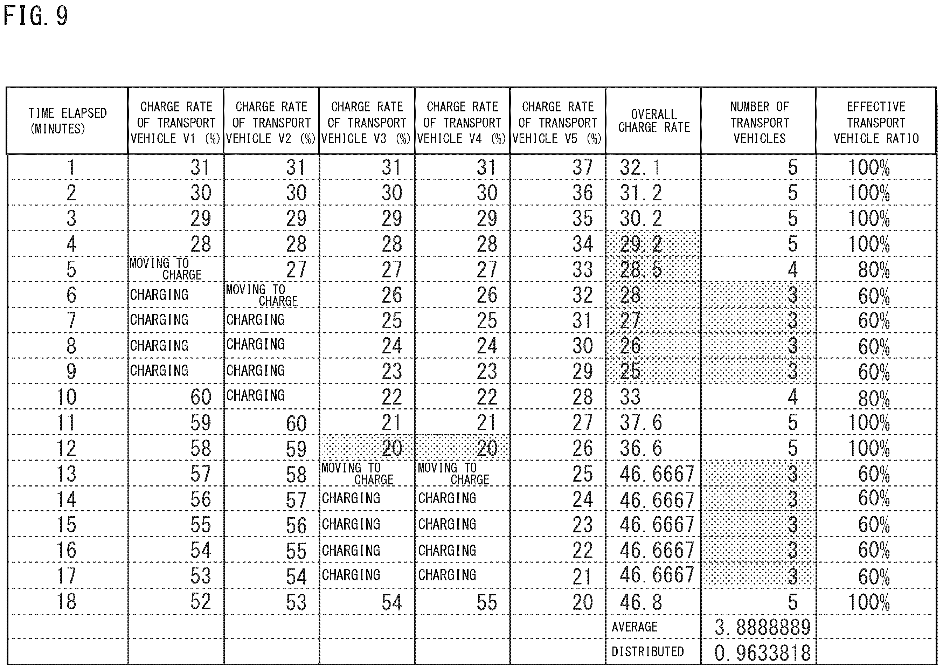

Fig. 9 is a diagram showing an example of a charging instruction processing image according to the embodiment. In Fig. 9, description is premised on that three chargers 30 are arranged, the battery 116 decreases by 1 percent per minute, the travel time for charging is 1 minute, and the charging time is 4 minutes. Also, in Fig. 9, as an example, the first threshold value (corresponding to the charging rate of the entire system) is "30" percent, and the second threshold value (corresponding to the charging rate of each individual transport vehicle 10) is "20" percent. In addition, in Fig. 9, the effective transport vehicle ratio is taken as an example of the system margin rate where the threshold value thereof is set to "60" percent.

As shown in Fig. 9, the controller 20 calculates the charge rate of the entire multiple transport vehicles 10 every minute, and recognizes it falling below the first threshold value of "30" percent as the overall charge rate becomes "29.2" percent when "4" minutes have elapsed. Here, the controller 20 treats transport vehicles V1, V2, V3, and V4 as charging targets. Then, the controller 20 instructs to charge any one of the transport vehicles 10, the transport vehicle 10 that is closest to the charger 30, or the transport vehicle 10 with the lowest charge rate among the transport vehicles V1, V2, V3, and V4. In the example shown in Fig. 9, the charge rates of the transport vehicles V1, V2, V3, and V4 are the same, the controller 20 may instruct to charge any transport vehicle 10, or the transport vehicle 10 closest to the charger 30, and it instructs to charge the transport vehicle V1, for example. Since there is an available charger 30 and there is a margin in the system margin rate (here, the effective transport vehicle ratio), the controller 20 instructs to charge the transport vehicle V2. Although the charging instructions to the transport vehicles V1, V2 are executed at different timings, they may be executed at the same timing. At this time, if the controller 20 instructs to charge either the transport vehicle V3 or V4, the system margin rate (here, the effective transport vehicle ratio) will fall below the threshold value of "60" percent, and therefore, the controller 20 does not instruct to charge the transport vehicles V3, V4.

Then, when "11" minutes have elapsed, the controller 20 recognizes the completion of charging the transport vehicles V1, V2. At this time, the controller 20 does not instruct to charge the transport vehicles V3, V4 because there is a margin in the system margin rate (here, the effective transport vehicle ratio), the charge rate of the entire system is not below the first threshold value of "30" percent and the individual charge rates are not below the second threshold value of "20" percent. When "12" minutes have elapsed, the controller 20 recognizes the individual charge rates of the transport vehicles V1, V2 falling below the second threshold value of "20" percent. The controller 20 then instructs to charge the transport vehicles V3, V4. Then, when "18" minutes have elapsed, the controller 20 recognizes the completion of charging the transport vehicles V3, V4. While there is a margin in the system margin rate and the charge rate of the entire system is not below the first threshold value when "19" minutes have elapsed, there is a possibility of the individual charge rate of the transport vehicle V5 falling below "20" percent, and therefore, an instruction to charge the transport vehicle V5 may be given.

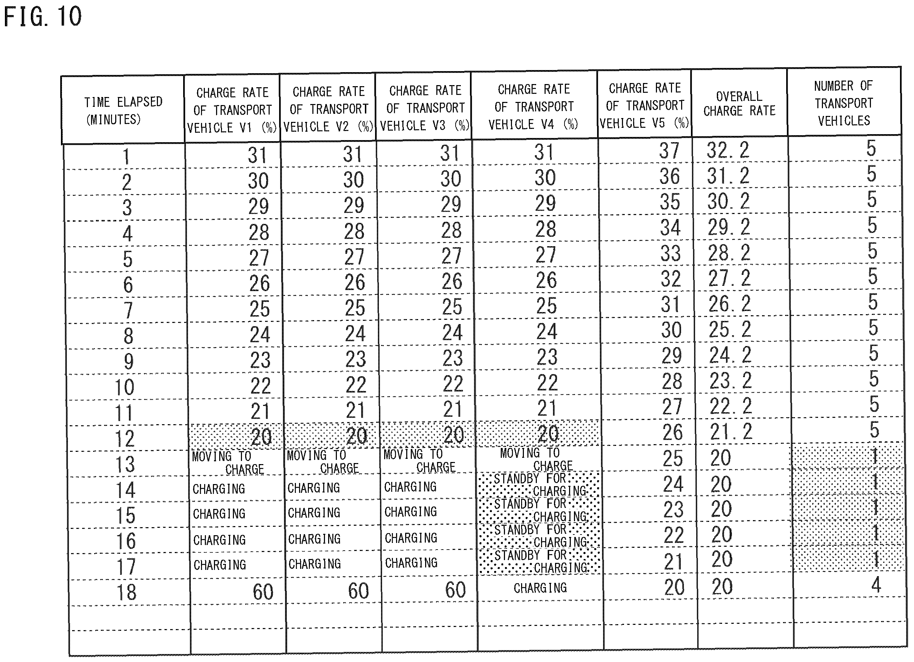

Fig. 10 is a diagram showing an example of a charging instruction processing image according to the conventional technique. As shown in Fig. 10, in the conventional technique, when "12" minutes have elapsed, the individual charge rates of the transport vehicles V1, V2, V3, and V4 fall below the threshold value (the second threshold value in the present embodiment), and charging becomes necessary. However, since there are three chargers, the transport vehicles V1, V2, and V3 are directed to the chargers, and the transport vehicle V4 is placed on standby for charging. At this time, the number of transport vehicles that are able to operate in the entire system will be "1" (transport vehicle V5), and this reduces the transport efficiency.

As described above, according to the transport vehicle system 100 of the present embodiment, any one of the transport vehicles 10 is instructed to start charging if the charge rate of the entire plurality of transport vehicles 10 is below the first threshold value, and each transport vehicle 10 the charge rate of which is below the second threshold value that is lower than the first threshold value is instructed to start charging. Thus, it is possible to suppress multiple transport vehicles 10 from being instructed to start charging at the same timing, thereby suppressing a decrease in the transport efficiency of the entire system. According to the transport vehicle system 100 of the present embodiment, charging instructions for the transport vehicles are given taking the system margin rate into account. Thus, it is possible to prevent situations where there is no transport vehicle 10 to which a transport instruction can be assigned. According to the transport vehicle system 100 of the present embodiment, the system margin rate is periodically checked while giving charging instructions to the transport vehicles 10. Thus, it is possible to prevent situations where transport vehicles 10 become unable to execute transport instructions due to a reduced charge rate. According to the transport vehicle system 100 of the present embodiment, the system margin rate is found using various information related to the transport efficiency. Thus, it is possible to suitably suppress a decrease in the transport efficiency of the entire system. According to the transport vehicle system 100 of the present embodiment, multiple transport vehicles 10 are not sent to charge at the same time. Thus, it is possible to suppress a decrease in the transport efficiency of the entire system. According to the transport vehicle system 100 of the present embodiment, the transport vehicles 10 are instructed to start charging in order from the transport vehicle 10 closest to the charger 30. When multiple transport vehicles 10 require charging, it is possible to improve charging efficiency. According to the transport vehicle system 100 of the present embodiment, the transport vehicles 10 are instructed to start charging in order from the transport vehicle 10 with the lowest charge rate. Thus, it is possible to prevent the increase in the number of transport vehicles 10 being unable to execute transport instructions due to a reduced charge rate. According to the transport vehicle system 100 of the present embodiment, state information is acquired through periodic communication between the multiple transport vehicles 10 and the controller 20. Thus, it is possible to identify transport vehicles 10 that are suitable for instructing charging. According to the transport vehicle system 100 of the present embodiment, the multiple transport vehicles 10 can move in the first direction D1 or the second direction D2 along the grid-patterned track R, and the charger 30 is provided so as to correspond to one of the grid cells of the grid-patterned track R. Thus, it is possible to apply the present invention to a transport vehicle system 100 arranged on a grid-patterned track R.

In addition, the following supplementary notes are disclosed in relation to the embodiment described above.
(Supplementary Note 1) A transport vehicle system comprising:
   a plurality of transport vehicles that transport articles; a controller that assigns a transport instruction to any one of the plurality of transport vehicles; and a charger that is located on a route along which the plurality of transport vehicles can travel and supplies electric power to the transport vehicles,
   wherein the controller includes a charging instructor that instructs to start charging each transport vehicle,
   wherein the charging instructor performs a first determination process to determine whether a charge rate of an entirety of the plurality of transport vehicles is below a first threshold value, and instructs to start charging at least any one of the transport vehicles if the charge rate of the entirety of the plurality of transport vehicles is determined as being below the first threshold value, and
   wherein the charging instructor performs a second determination process to determine whether the charge rate of each transport vehicle is below a second threshold value that is lower than the first threshold value, and instructs to start charging each transport vehicle if the charge rate of the transport vehicle is determined as being below the second threshold value.
(Supplementary Note 2) The transport vehicle system according to supplementary note 1,
   wherein the charging instructor checks a system margin rate, which indicates a degree of margin in the entirety of the plurality of transport vehicles, at predetermined timings against processing of the transport instruction,
   wherein the charging instructor instructs to start charging the any one of the transport vehicles if the degree of margin indicated by the system margin rate is higher than or equal to a predetermined degree and also the charge rate of the entirety of the plurality of transport vehicles is determined as being below the first threshold value, and
   wherein the charging instructor instructs to start charging a transport vehicle if the degree of margin indicated by the system margin rate is higher than or equal to the predetermined degree and also the charge rate of the transport vehicle is determined as being below the second threshold value.
(Supplementary Note 3) The transport vehicle system according to supplementary note 2,
   wherein the charging instructor checks the system margin rate periodically at the predetermined timings.
(Supplementary Note 4) The transport vehicle system according to supplementary note 2 or 3,
   wherein the charging instructor checks whether or not at least one of following is satisfied: an effective transport vehicle ratio, which serves as the system margin rate to represent a proportion of transport vehicles that are on standby relative to the entirety of the plurality of transport vehicles, is higher than or equal to a predetermined ratio; a transport volume of the entirety of the plurality of transport vehicles is below a predetermined transport volume; and a utilization rate of the entirety of the plurality of transport vehicles is below a predetermined utilization rate.
(Supplementary Note 5) The transport vehicle system according to any one of supplementary notes 1 to 4,
   wherein the charging instructor instructs to start charging two or more of the transport vehicles at different timings.
(Supplementary Note 6) The transport vehicle system according to supplementary note 5,
   wherein the charging instructor instructs to start charging the transport vehicles in order from the transport vehicle closest to the charger.
(Supplementary Note 7) The transport vehicle system according to supplementary note 5,
   wherein the charging instructor instructs to start charging the transport vehicles in order from the transport vehicle with the lowest charge rate.
(Supplementary Note 8) The transport vehicle system according to any one of supplementary notes 1 to 7,
   wherein the controller acquires state information of the plurality of transport vehicles through periodic communication with the plurality of transport vehicles.
(Supplementary Note 9) The transport vehicle system according to any one of supplementary notes 1 to 8,
   wherein the plurality of transport vehicles can move in a first direction and a second direction along a grid-patterned track that extends in a first direction and a second direction intersecting the first direction, and
   wherein the charger is provided so as to correspond to one of grid cells of the grid-patterned track.
(Supplementary Note 10) A method of controlling transport vehicles in a transport vehicle system including a plurality of transport vehicles that transport articles, a controller that assigns a transport instruction to any one of the plurality of transport vehicles, and a charger that is located on a route along which the plurality of transport vehicles can travel and supplies electric power to the transport vehicles,
   the method comprising steps, implemented by the controller, of:
   performing a first determination process to determine whether a charge rate of an entirety of the plurality of transport vehicles is below a first threshold value, and instructing to start charging at least any one of the transport vehicles if the charge rate of the entirety of the plurality of transport vehicles is determined as being below the first threshold value; and
   performing a second determination process to determine whether the charge rate of each transport vehicle is below a second threshold value that is lower than the first threshold value, and instructing to start charging each transport vehicle if the charge rate of the transport vehicle is determined as being below the second threshold value.

The embodiment of the present invention has been described above. However, the technical scope of the invention is not limited to the description of the above embodiment. It is apparent to those skilled in the art that various modifications or improvements can be added to the above embodiment. The technical scope of the present invention also encompasses one or more of such modifications or improvements. One or more of the requirements described in the above embodiment may be omitted in some cases. Furthermore, one or more of the requirements described in the above embodiment may be combined where appropriate. The contents of all documents cited in the detailed description of the present invention are incorporated herein by reference to the extent permitted by law.

It should be noted that the technical scope of the present invention is not limited to the mode described in the above embodiment. One or more of the requirements described in the above embodiment may be omitted in some cases. One or more of the requirements described in the above embodiment may be combined where appropriate. The contents of Japanese Patent Application No. 2022-078653 and all documents cited in the detailed description of the present invention are incorporated herein by reference to the extent permitted by law.

### Description of Reference Signs

- 10:: Transport vehicle
- 20:: Controller
- 21:: Charging instructor
- 30:: Charger
- 100:: Transport vehicle system

## Claims

1. A transport vehicle system comprising:
a plurality of transport vehicles that transport articles;
a controller that assigns a transport instruction to any one of the plurality of transport vehicles; and
a charger that is located on a route along which the plurality of transport vehicles can travel and supplies electric power to the transport vehicles,
wherein the controller includes a charging instructor that instructs to start charging each transport vehicle,
wherein the charging instructor performs a first determination process to determine whether a charge rate of an entirety of the plurality of transport vehicles is below a first threshold value, and instructs to start charging at least any one of the transport vehicles if the charge rate of the entirety of the plurality of transport vehicles is determined as being below the first threshold value, and
wherein the charging instructor performs a second determination process to determine whether the charge rate of each transport vehicle is below a second threshold value that is lower than the first threshold value, and instructs to start charging each transport vehicle if the charge rate of the transport vehicle is determined as being below the second threshold value.

2. The transport vehicle system according to claim 1,
wherein the charging instructor
checks a system margin rate, which indicates a degree of margin in the entirety of the plurality of transport vehicles, at predetermined timings against processing of the transport instruction,
instructs to start charging at least the any one of the transport vehicles if the degree of margin indicated by the system margin rate is higher than or equal to a predetermined degree and also the charge rate of the entirety of the plurality of transport vehicles is determined as being below the first threshold value, and
instructs to start charging a transport vehicle if the degree of margin indicated by the system margin rate is higher than or equal to the predetermined degree and also the charge rate of the transport vehicle is determined as being below the second threshold value.

3. The transport vehicle system according to claim 2,
wherein the charging instructor checks the system margin rate periodically at the predetermined timings.

4. The transport vehicle system according to claim 2 or 3,
wherein the charging instructor checks whether or not at least one of following is satisfied: an effective transport vehicle ratio, which serves as the system margin rate to represent a proportion of transport vehicles that are on standby relative to the entirety of the plurality of transport vehicles, is higher than or equal to a predetermined ratio; a transport volume of the entirety of the plurality of transport vehicles is below a predetermined transport volume; and a utilization rate of the entirety of the plurality of transport vehicles is below a predetermined utilization rate.

5. The transport vehicle system according to any one of claims 1 to 3,
wherein the charging instructor instructs to start charging two or more of the transport vehicles at different timings.

6. The transport vehicle system according to claim 5,
wherein the charging instructor instructs to start charging the transport vehicles in order from the transport vehicle closest to the charger.

7. The transport vehicle system according to claim 5,
wherein the charging instructor instructs to start charging the transport vehicles in order from the transport vehicle with the lowest charge rate.

8. The transport vehicle system according to any one of claims 1 to 3,
wherein the controller acquires state information of the plurality of transport vehicles through periodic communication with the plurality of transport vehicles.

9. The transport vehicle system according to any one of claims 1 to 3,
wherein the plurality of transport vehicles can move in a first direction and a second direction along a grid-patterned track that extends in a first direction and a second direction intersecting the first direction, and
wherein the charger is provided so as to correspond to one of grid cells of the grid-patterned track.

10. A method of controlling transport vehicles in a transport vehicle system including a plurality of transport vehicles that transport articles, a controller that assigns a transport instruction to any one of the plurality of transport vehicles, and a charger that is located on a route along which the plurality of transport vehicles can travel and supplies electric power to the transport vehicles,
the method comprising steps, implemented by the controller, of:
performing a first determination process to determine whether a charge rate of an entirety of the plurality of transport vehicles is below a first threshold value, and instructing to start charging at least any one of the transport vehicles if the charge rate of the entirety of the plurality of transport vehicles is determined as being below the first threshold value; and
performing a second determination process to determine whether the charge rate of each transport vehicle is below a second threshold value that is lower than the first threshold value, and instructing to start charging each transport vehicle if the charge rate of the transport vehicle is determined as being below the second threshold value.
